# FASCICULE DE BREVET EUROPEEN

(11) **EP 0 442 826 B1**
(45) Date de publication et mention de la délivrance du brevet: **20.04.1994**
(21) Numéro de dépôt: 91420007.6
(22) Date de dépôt: 08.01.1991
(51) Int. Cl.: H05K 7/18, F16B 12/50

(54) **Armoire pour appareillage électrique à ossature assemblée par des tripodes**
Schrank für eine elektrische Geräteeinheit mit einem Gerüst, zusammengesetzt aus Dreibeinen
Switchboard for electrical apparatus with a frame composed of tripods

(30) Priorité: 15.01.1990 FR 9000473
(43) Date de publication de la demande: 21.08.1991
(73) Titulaire: MERLIN GERIN, F-38240 Meylan (FR)
(72) Inventeur: Betsch, Frédéric, F-38050 Grenoble Cedex (FR); Carle, Pierre, F-38050 Grenoble Cedex (FR); Xaux, Luis, F-38050 Grenoble Cedex (FR); Goutay, Roland, F-38050 Grenoble Cedex (FR)
(74) Mandataire: Ritzenthaler, Jacques

(56) Documents cités:
- DE-A- 2 627 260
- DE-A- 2 723 980
- DE-A- 3 033 114
- DE-U- 8 321 868

## Description

L'invention est relative à une armoire de logement d'appareillage électrique ayant une ossature constituée de profilés allongés tubulaires, assemblés dans les angles par des pièces de jonction en forme de polypode présentant sur chacune de ses faces d'assemblage un pied emmanché à faible jeu dans l'extrémité du profilé, et dont la partie emmanchée présente une entaille dont l'élargissement par l'action d'une vis engagée dans un trou taraudé provoque une expansion du pied et un coincement du profilé sur la pièce de jonction.

Les armoires de logement d'appareillage électrique ou électronique sont de plus en plus volumineuses, et il est avantageux de pouvoir les monter sur place à partir d'éléments standards. Elles sont généralement constituées de panneaux métalliques fixés par tout moyen approprié à un bâti ou à une ossature elle-même réalisée par l'assemblage de montants et de traverses, constitués par des profilés tubulaires perforés qui sont assemblés aux angles par des pièces de jonction. La solidité et la rigidité de l'ossature et de ce fait de l'armoire, sont tributaires de la qualité de ces jonctions aux angles de l'ossature. La fixation par soudage répond à ce besoin de rigidité, mais elle est difficile à mettre en oeuvre, et rend quasi-impossible tout démontage ultérieur de l'armoire (EP-A-0144955).

Le document DE-A-2627260 fait connaître un assemblage de profilés par vis, chaque profilé étant solidarisé à une pièce cubique en forme de tripode. Chaque pied du tripode est emboîté dans l'extrémité d'un profilé, et ces derniers sont maintenus et solidarisés à la pièce cubique par vissage. La vis est introduite par un orifice incliné du profilé, et sa tête prend appui sur un rebord ménagé sur le profilé, permettant lors du vissage de rapprocher et d'accoster le profilé sur la pièce cubique d'angle. Ce procédé de fixation permet un démontage aisé mais nécessite une perforation et un pliage, au voisinage de l'extrémité du profilé pour réaliser le passage et le maintien de la vis et de sa tête.Les profilés ne peuvent plus être réalisés à partir de profils de grande longueur par simple tronçonnage, mais nécessitent un usinage difficilement réalisable sur place.

L'accès aux vis de fixation n'est pas toujours aisé, et une fixation solide implique au moins deux vis disposées symétriquement sur chaque profilé.

Un autre assemblage connu (DE-A-1962561) à emboîtement du profilé sur un pied d'un tripode fait usage d'une vis latérale qui traverse une perforation ou fente standard du profilé, et se visse dans un alésage taraudé du pied emboîté dans le profilé. Cette vis s'étend tranversalement, et n'exerce qu'un serrage latéral insuffisant pour assurer une rigidité de l'assemblage. Un assemblage du même type est décrit dans le document DE-A-3033114.

Dans un autre assemblage connu (US-C-4610561), un écrou est introduit dans l'extrémité du profilé, et solidarisé à ce dernier par soudage ou par auto-expansion. Une vis traversant la pièce cubique de jonction et se vissant dans l'écrou permet de solidariser le profilé à cette pièce cubique en forme de tripode. Le profilé est simplement emboîté sur le tripode, et le jeu existant obligatoirement entre le pied et le profilé peut être à l'origine de défauts de rigidité de l'assemblage.

Le document DE-A-2723980 concerne un assemblage de deux profilés carrés, dont les extrémités sont emboîtées sur un pied fendu. Le serrage d'une vis provoque l'expansion du pied et la fixation par coincement du profilé. La vis est accessible à travers un trou ménagé dans le profilé mais ne coopère pas avec ce dernier.

La demande de brevet français 8901664 du 7.2.89 décrit un dispositif de jonction à coin, dont le déplacement par serrage d'une vis provoque le coincement et l'accostage du profilé sur la pièce de jonction. Ce dispositif est volumineux et compliqué.

La présente invention a pour but de permettre la réalisation d'un assemblage rigide par vissage facilement démontable et applicable à des profilés qui ne sont pas spécialement aménagés et ce but est atteint par la mise en oeuvre des caractéristiques de la revendication 1.

Le serrage de la vis de fixation exerce un effort d'expansion du pied inséré dans le profilé pour coincer ce dernier sur la pièce de jonction. Cette action de coincement, assure une rigidité de l'assemblage indépendante des tolérances de fabrication et cette rigidité peut être augmentée en faisant passer la vis par un orifice du profilé en regard d'un trou taraudé percé dans l'une des branches du pied définie par l'entaille. L'extrémité de la vis bute contre l'autre branche de façon à élargir l'entaille lors du vissage. Le diamètre de cet orifice est supérieur à celui du trou taraudé et en position emmanchée à fond, l'orifice est légèrement décalé vers l'extrémité de la branche tout en restant en regard du trou taraudé. La base de la tête de la vis est tronconique pour engager le bord intérieur de l'orifice et exercer sur le profilé une force d'emmanchement et d'accostage du profilé sur la pièce de jonction.

Dans le cas général d'une armoire parallélépipèdique, les pièces d'angles sont des tripodes permettant l'assemblage des trois profilés s'étendant suivant les trois arêtes d'angle, mais il est clair que l'invention est applicable à une pièce de jonction à deux pieds ou à plus grand nombre de pieds, si l'armoire a une forme différente. La pièce de jonction est de préférence une pièce moulée et les pieds assurent un parfait positionnement des profilés par rapport à cette pièce de jonction. Chaque pied constitue un coin expansible dont la dilatation ou la contraction est obtenue par un simple vissage.

Les profilés sont avantageusement de section triangulaire fermée, mais l'invention est applicable à l'assemblage de profilés de section différente. L'armoire est généralement constituée de 12 profilés formant les montants et les traverses de l'ossature, et de huit pièces de jonction identiques disposées dans chacun des angles de l'ossature. Les profilés présentent sur au moins deux de leurs faces des rangées de perforations permettant la fixation d'appareils ou de supports d'appareillage en différentes positions et suivant des orientations perpendiculaires d'une manière bien connue. Le pied du tripode peut pénétrer sur une longueur suffisante du profilé et obturer ainsi plusieurs perforations rendant impossible toute fixation au voisinage de la pièce d'angle. Selon un développement de l'invention, la pièce de blocage comporte des alésages taraudés en regard des perforations obturées, pour permettre un vissage direct dans la pièce de blocage des vis de fixation. Le mode d'assemblage selon l'invention conserve ainsi intégralement les possibilités de fixation de traverses, sans complication ou opération particulière.

L'entaille est de préférence pratiquée à proximité de l'une des arêtes, notamment à angle droit lors d'une section à triangle rectangle pour constituer une branche de section réduite d'une certaine élasticité.Le trou taraudé est percé dans la branche de section supérieure suivant la bissectrice de l'angle droit. La section réduite est avantageusement un carré.

D'autres avantages et caractéristiques ressortiront plus clairement de la description qui va suivre, d'un mode de mise en oeuvre de l'invention, donné à titre d'exemple non limitatif et représenté aux dessins annexés dans lesquels:

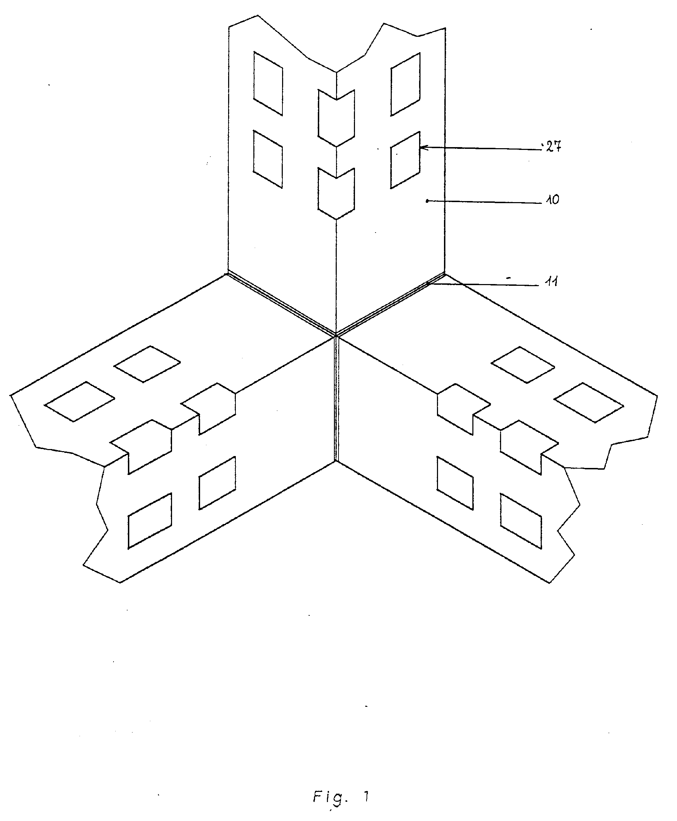

- la figure 1 est une vue schématique en perspective d'un angle d'une ossature d'une armoire électrique selon l'invention;

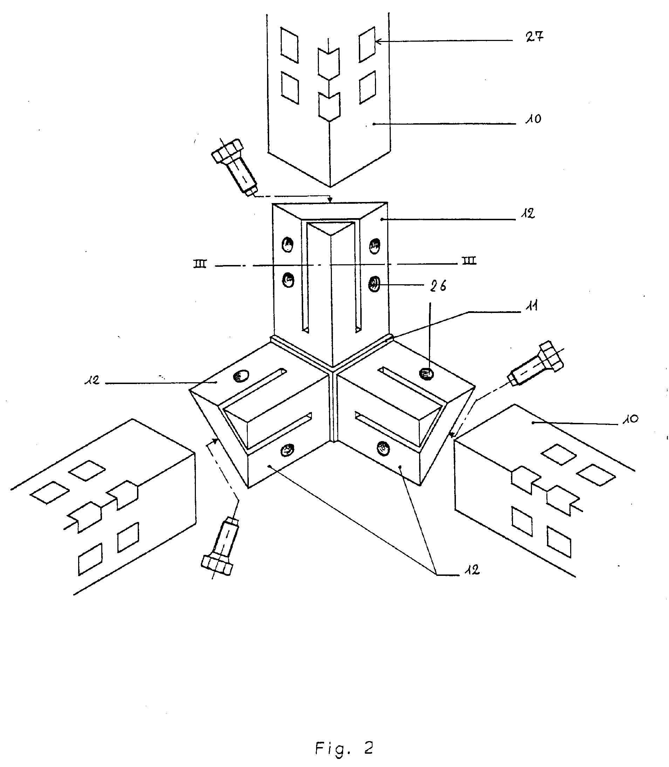

- la figure 2 est une vue éclatée de l'angle représenté sur la figure 1;
- la figure 3 est une vue en coupe suivant la ligne III-III de la figure 2;
- la figure 4 est une coupe suivant la ligne IV-IV de la figure 3, montrant l'assemblage avant serrage de la vis avec des jeux agrandis;
- la figure 5 est une vue analogue à celle de la figure 4, montrant l'assemblage après serrage de la vis.

Sur les figures, une ossature d'une armoire d'appareillage électrique comporte des profilés standards 10 de section triangulaire rectangle fermée, assemblés aux angles par des pièces de jonction 11 en forme de tripode. Les trois profilés 10 de l'un des angles de l'ossature sont chacun emmanchés par l'une de leurs extrémités à faible jeu sur l'un des pieds 12 du tripode 11. L'ensemble est symétrique et les trois assemblages sont identiques,seul l'un étant décrit en détail par la suite.Chaque pied 12 s'étend perpendiculairement à la face d'accostage 13 du profilé 10 sur le tripode 11 et dans la direction longitudinale de ce profilé.

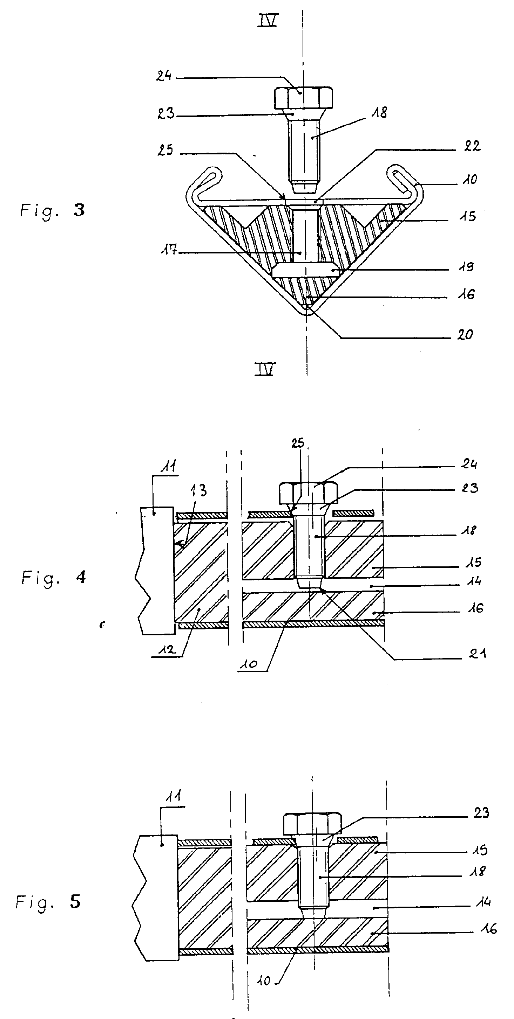

Selon l'invention le pied 12 de section triangulaire rectangle, porte une entaille longitudinale 14 qui s'étend à partir de l'extrémité libre sur une grande partie de la longueur du pied pour définir deux branches 15,16 en forme de fourche. L'une des branches 15 est percée par un trou taraudé transversal 17, susceptible de recevoir une vis 18. En se référant plus particulièrement à la figure 3, on voit que l'entaille 14 constituée par deux fentes 19 orthogonales est voisine de l'arête 20 à angle droit. Les fentes 19 parallèles respectivement aux deux ailes du pied 12 formant l'angle droit, définissent une branche 16 de section carrée relativement faible. Le trou taraudé 17 s'étend dans le plan bissecteur de l'angle droit. Lors du vissage de la vis 18 dans le trou 17 l'extrémité 21 de la vis 18 vient buter contre la branche opposée 16 et provoque l'élargissement de l'entaille 14 avec expansion du pied 12 qui vient se coincer contre la paroi interne du profilé 10. La forme triangulaire assure un coincement en toutes directions.

La vis 18 traverse un orifice 22 ménagé dans le profilé 10 en regard du trou taraudé 17 et dont le diamètre est légèrement supérieur à celui du trou 17, dont l'entrée est avantageusement évasée.La base 23 de la tête 24 de la vis 18 est tronconique. Cet orifice 22 est dans la position emmanchée, représentée à la figure 4, légèrement décalé par rapport au trou taraudé 17 vers l'extrémité libre du pied 12, de manière que le bord intérieur 25, du côté du tripode 11, de l'orifice 22 affleure sensiblement avec le bord intérieur du trou taraudé 17. La longueur de la vis 18 est choisie pour que la base tronconique 23 engage le bord intérieur 25 avant que l'extrémité 21 de la vis 18 bute sur la branche opposée 16. En poursuivant le vissage, la base tronconique 23 pousse le profilé 10 contre le tripode 11 et par la suite la vis 18 bute sur la branche opposée 16 en povoquant l'expansion du pied et le coincement (figure 5). De légères imperfections sont compensées par un matage du bord 25 de l'orifice 22 sous l'action de la vis 18 et des essais ont montré que l'effet combiné d'accostage du profilé 10 sur le tripode 11 et de coincement du pied 12 sur le profilé 10 est toujours obtenu.

La réalisation de l'assemblage est simple puisqu'il suffit d'emmancher le profilé 10 sur le pied 12, de mettre en place la vis 18 et de la serrer. Le démontage est obtenu par desserrage et enlèvement de la vis 18, le pied 12 reprenant sa forme contractée par simple élasticité.

Les pieds 12 présentent des trous filetés 26 en regard des perforations 27 des profilés 10 pour la fixation par vis de traverses ou autres supports.

Il est clair que les branches 15,16 peuvent avoir des formes différentes déterminées par la forme de l'entaille 14, celle-ci pouvant par exemple être plane pour délimiter d'une part une branche triangulaire 16 de petite section et d'autre part une branche trapézoïdale 15.Les deux branches 15,16 peuvent être de section comparable et l'élasticité peut être obtenue par un amincissement ou une section restreinte. L'entaille 14 n'est pas obligatoirement dans l'un des angles de la section triangulaire, mais cette solution est préférentielle.

## Revendications

1. Armoire de logement d'appareillage électrique ayant une ossature constituée de profilés (10) allongés tubulaires, assemblés dans les angles par des pièces de jonction (11) en forme de polypode présentant sur chacune de ses faces d'assemblage un pied (12) emmanché à faible jeu dans l'extrémité du profilé, et dont la partie emmanchée présente une entaille (14) dont l'élargissement par l'action d'une vis (18) engagée dans un trou taraudé (17) provoque une expansion du pied (12) et un coincement du profilé (10) sur la pièce de jonction (11), caractérisée en ce que la vis (18) traverse un orifice (22) ménagé dans le profilé (10), dont le diamètre est supérieur à celui du trou taraudé et légèrement décalé par rapport audit trou taraudé dans la direction longitudinale vers l'extérieur de la pièce de jonction, et en ce que la base de la tête (24) de la vis est tronconique pour engager le bord intérieur de l'orifice afin d'exercer lors du serrage une force d'accostage du profilé sur la pièce de jonction.

2. Armoire selon la revendication 1, caractérisée en ce que ladite entaille (14) s'étend dans la direction longitudinale de la partie emmanchée du pied (12) et définit deux branches (15,16), que l'une (15) des branches présente un trou taraudé orienté, perpendiculairement à ladite direction longitudinale, vers l'autre branche (16) et que la vis (18) est vissée dans ledit trou (17) en venant en butée de l'autre branche (16) pour l'écarter de ladite une branche (15).

3. Armoire selon l'une des revendications précédentes, caractérisée en ce que le prolilé (10) et le pied (12) ont une section triangulaire et que l'entaille (14) est pratiquée à proximité de l'une (20) des arêtes pour constituer une branche élastique (16) et que le trou taraudé est ménagé dans la branche (15) de section supérieure.

4. Armoire selon la revendication 3, caractérisée en ce que ladite section est un triangle rectangle, que l'entaille (14) est pratiquée à proximité de l'angle droit du triangle et que le trou taraudé (17) s'étend dans la bissectrice de cet angle droit.

5. Armoire selon la revendication 4, caractérisée en ce que l'entaille (14) est constituée de deux fentes (19) perpendiculaires dont les côtés sont parallèles aux ailes du pied (12) formant l'angle droit pour définir une branche (16) de section carrée.

## Patentansprüche

1. Schrank zur Aufnahme von Elektrogeräten mit einem Rahmengestell aus länglichen Rohrprofilen (10), die an den Eckpunkten über mehrere Anschlußseiten aufweisende Verbindungselemente (11) miteinander verbunden sind, die an jeder Verbindungsfläche ein mit geringem Spiel in das Ende des Profils eingestecktes Steckelement (12) aufweisen und in deren eingestecktem Teil ein Schlitz (14) ausgebildet ist, dessen Verbreiterung durch Einwirkung einer durch eine Gewindebohrung (17) geführten Schraube (18) die Ausdehnung des Steckelements (12) und ein Festklemmen des Profils (10) auf dem Verbindungselement (11) bewirkt, dadurch gekennzeichnet, daß die Schraube (18) durch eine im Profil (10) ausgebildete Öffnung (22) geführt wird, die einen größeren Durchmesser aufweist als die Gewindebohrung und gegenüber der genannten Gewindebohrung in Längsrichtung zur Außenseite des Verbindungselements hin gesehen leicht versetzt angeordnet ist, und daß der Kragen des Schraubenkopfes (24) konisch geformt ist, um sich auf dem Innenrand der Öffnung abzustützen und so beim Anziehen der Schraube eine Kraft auf das Profil auszuüben, die es mit dem Verbindungselement zusammenführt.

2. Schrank nach Anspruch 1, dadurch gekennzeichnet, daß der genannte Schlitz (14) zur Ausbildung von zwei Stegen (15, 16) in Längsrichtung des eingesteckten Teils des Steckelements (12) verläuft, einer (15) der Stege eine rechtwinklig zur genannten Längsrichtung angeordnete auf den anderen Steg (16) gerichtete Gewindebohrung aufweist und die Schraube (18) in die genannte Gewindebohrung (17) eingedreht wird und dabei in Anschlag gegen den anderen Steg (16) gelangt, um diesen von dem genannten Steg (15) zu entfernen.

3. Schrank nach einem der vorhergehenden Ansprüche, dadurch gekennzeichnet, daß das Profil (10) und das Steckelement (12) einen dreieckigen Querschnitt aufweisen, der Schlitz (14) zur Bildung eines elastischen Stegs (16) in der Nähe einer (20) der Kanten ausgebildet und die Gewindebohrung in dem Steg (15) mit dem größerem Querschnitt ausgeführt ist.

4. Schrank nach Anspruch 3, dadurch gekennzeichnet, daß der genannte Querschnitt die Form eines rechtwinkligen Dreiecks aufweist, der Schlitz (14) in der Nähe des rechten Winkels des Dreiecks ausgebildet ist und die Gewindebohrung (17) in der Ebene der Winkelhalbierenden dieses rechten Winkels verläuft.

5. Schrank nach Anspruch 4, dadurch gekennzeichnet, daß der Schlitz (14) aus zwei rechtwinklig zueinander stehenden Spalten (19) besteht, deren Seiten jeweils parallel zu den beiden den rechten Winkel bildenden Flanken des Steckelements (12) verlaufen, um so einen Steg (16) mit quadratischem Querschnitt zu bilden.

## Claims

1. A cabinet for housing electrical switchgear having a framework made up of elongated tubular girder sections (10), assembled in the corners by joining parts (11) in the form of a polypod having on each of its assembly faces a leg (12) slotted with small clearance into the end of the girder section, and whose slotted-in part presents a notch (14) the widening of which due to the action of a screw (18) engaged in a drilled hole (17) causes expansion of the leg (12) and wedging of the girder section (10) onto the joining part (11), characterized in that the screw (18) passes through an orifice (22) arranged in the girder section (10), whose diameter is greater than that of the drilled hole and slightly offset with respect to said drilled hole in the longitudinal direction towards the outside of the joining part, and that the base of the head (24) of the screw is frustum-shaped to engage the inside edge of the orifice in order to exert a force engaging the girder section onto the joining part when tightening takes place.

2. The cabinet according to claim 1, characterized in that said notch (14) extends in the longitudinal direction of the slotted-in part of the leg (12) and defines two branches (15, 16), that one (15) of the branches presents a drilled hole oriented perpendicularly to said longitudinal direction towards the other branch (16) and that the screw (18) is screwed into said hole (17) and comes up against the other branch (16) to move it away from said one branch (15).

3. The cabinet according to either of the above claims, characterized in that the girder section (10) and leg (12) are of triangular cross-section and that the notch (14) is achieved near to one (20) of the edges to form an elastic branch (16) and that the drilled hole is arranged in the branch (15) of larger cross-section.

4. The cabinet according to claim 3, characterized in that said cross-section is a triangular rectangle cross-section, that the notch (14) is achieved near to the right angle of the triangle and that the drilled hole (17) extends in the line bissecting this right angle.

5. The cabinet according to claim 4, characterized in that the notch (14) is formed by two perpendicular slots (19) whose sides are parallel to the wings of the leg (12) forming the right angle to define a branch (16) of square cross-section.
